# EUROPEAN PATENT APPLICATION

(11) **EP 4 270 768 A1**
(43) Date of publication of application: **01.11.2023**
(21) Application number: 21934647.5
(22) Date of filing: 08.12.2021
(51) Int. Cl.: H02P 6/15

(54) **CIRCUIT STRUCTURE FOR IMPLEMENTING LEAD/LAG COMMUTATION OF ELECTRIC MOTOR**

(30) Priority: 31.03.2021 CN 202110351196
(71) Applicant: CRM ICBG (WUXI) CO., LTD., Wuxi, Jiangsu 214135 (CN)
(72) Inventor: ZHANG, Zhengrui, Wuxi, Jiangsu 214135 (CN); WANG, Sang, Wuxi, Jiangsu 214135 (CN); ZHAO, Xudong, Wuxi, Jiangsu 214135 (CN)
(74) Representative: Canzler & Bergmeier Patentanwälte Partnerschaft mbB
(86) International application number: PCT/CN2021/136543
(87) International publication number: WO 2022/206011

(57) **Abstract**

The present invention relates to a circuit structure for implementing lead/lag commutation of an electric motor. The circuit structure comprises: a Hall angle mapping module for receiving three Hall signals generated by a Hall module of an external electric motor and respectively configuring the Hall signals and converting same into Hall synchronization angle values; a Hall angle update module for selecting a corresponding angle update mode according to the internal logic of the circuit structure; a three-phase angle generation module for performing time-sharing computation on angles generated by the Hall angle update module, so as to generate current three-phase angle signals; an angle conversion module for performing corresponding angle conversion on the three-phase angle signals generated by the three-phase angle generation module; and a PWM generation module for generating three-phase six-way complementary PWM waveforms. By means of the circuit structure of the present invention, only some additional logic circuit modules are added, such that a phase lead/lag operation can be easily implemented, and smooth switching can be realized between a square wave control mode and a sine wave control mode.

## Description

### CROSS REFERENCE TO RELATED APPLICATION

The present application claims the benefit of priority to Chinese Patent Application No. CN 202110351196.9, entitled "Circuit Structure for Realizing Advanced and Lagging Commutation of Motors", filed with CNIPA on March 31, 2021, the disclosure of which is incorporated herein by reference in its entirety for all purposes.

### FIELD OF THE INVENTION

The present disclosure generally relates to square-wave motor commutation, in particular to advanced and lagging commutation of motors, more specifically to a circuit structure for realizing advanced and lagging commutation of motors.

### BACKGROUND OF THE INVENTION

Brushless permanent magnet motors have a simple structure, high power density, long service life, and are easy to maintain. As a result, they are occupying an increasing market share and are the preferred choice for motor design. The control systems for brushless motors often use position sensors to detect rotor position, including rotary transformers, encoders, and HALL sensors. HALL sensors are widely used in scenarios where control accuracy does not need to be high, due to their excellent anti-interference ability and ease of installation. However, the presence of position sensors reduces reliability of the motors and increases their size and cost. In recent years, with the development of control technology and the improvement of control chip performance, high-speed brushless permanent magnet motors without position sensors have become increasingly common. There are several methods for detecting rotor position in brushless DC motors without position sensors, such as magnetic flux linkage estimation, freewheeling diode current detection, and back electromotive force detection. Among these methods, the method based on the back electromotive force in coils is the most mature and widely used.

For HALL sensors, load increase can cause magnetic field distortion, which can further cause HALL commutation signals to lag behind, i.e., lagging commutation. In order to improve motor efficiency, advanced commutation is an inevitable choice. Regarding the back electromotive force in coils, if the hardware delay of back electromotive force signals caused by the delay of filtering elements is not large, it is possible to take advantage of the fact that the zero-crossing point of the back electromotive force is 30 degrees ahead of the commutation timing, to achieve advanced commutation by reducing the delay time; however, for circuits where the hardware delay is severe, advanced commutation can only be achieved by delaying the back electromotive force signal of the previous phase, which in turn increases the code complexity.

In most applications without position sensors, only software-level control of commutation signals is performed. For example, Chinese patent CN111264025 discloses A Method for Operating a Motor using Field Oriented Control (FOC) in magnetic flux linkage control to perform advance/lag control. It requires a series of calculating operations, such as current sampling, angle calculation, torque control, and PWM generation in each PWM cycle to ensure that the advance angle of the motor's torque does not exceed the critical angle of operation of the motor or generator, and generates sine waves and trapezoidal waves. This series of operations requires high performance from the main micro-controller unit, which increases control costs. For example, Chinese patent CN201610542908.4 discloses A control method for permanent magnet brushless motors, which calculates the rotor magnetic flux linkage by detecting the phase voltages and phase currents of the motor, and integrates the phase currents to obtain an integrated current signal. The phase difference between this integrated current signal and the rotor magnetic flux linkage is the phase difference between the phase current and the back electromotive force. Then, by detecting and compensating for the phase difference between the rotor magnetic flux linkage and the integrated current signal, closed-loop control is formed for this phase difference. The output value of this closed loop is the commutation correction value, which allows the motor to commutate at the optimal commutation point. This solution, like the above patent CN111264025 "A Method for Operating a Motor", faces a problem that it requires high computing power from the main micro-controller unit, which increases the design cost. For example, Chinese patent CN104767435 disclosure A real-time correction method for commutation phases of sensorless brushless motors based on neutral point voltage, which determines current commutation phase errors by measuring a difference between virtual neutral point voltages 30 degrees before and after the commutation point, and uses this difference as commutation error feedback to achieve real-time correction of commutation phases of trapezoidal waves. However, this solution has a problem with insufficient accuracy at low speed. For example, Chinese patent CN106452225 discloses A real-time commutation phase correction system and method for brushless DC motors without position sensors, which uses a sampling voltage value at the moment when an off-phase voltage Vt is at tx to compare with half of a DC bus voltage of a three-phase bridge inverter circuit (i.e., Ud/2), calculates a commutation position correction angle ΔΘ according to the resulted difference, which is then adjusted by PI in order to achieve the correction of the commutation phase of the brushless DC motor without position sensor. ΔΘ ≈ arcsin ((2Vt-Ud)/2Ec), where Ec is the back electromotive force in coils, and is not directly available. Ec is close to Ud at high speed, so it can be replaced by Ud, but the accuracy will be affected in this case; however, if a higher accuracy is required, the calculation of Ec in real time at high speed is still needed, which increases the burden of the main control chip and raises the requirements for chip performance.

### SUMMARY OF THE INVENTION

One or more aspects of the present disclosure overcome the above-mentioned shortcomings of the prior art and provide a simple, efficient and convenient circuit structure for realizing advanced and lagging commutation of motors.

The circuit structure for realizing advanced and lagging commutation of motors of the present disclosure is as follows:
the circuit structure includes:
a HALL angle mapping module, connected to a HALL module of an external motor, for receiving three HALL signals generated by the HALL module and converting the three HALL signals into HALL synchronous angle values, respectively;
a HALL angle updating module, connected to the HALL angle mapping module, for selecting a corresponding angle updating mode according to internal logic of the circuit structure;
a three-phase angle generation module, connected to the HALL angle updating module, for performing a time-sharing calculation of angles generated by the HALL angle updating module to generate a three-phase angle signal corresponding to the three HALL signals;
an angle conversion module, connected to the three-phase angle generation module, for performing an angle conversion on the three-phase angle signal generated by the three-phase angle generation module; and
a PWM generation module, connected to the angle conversion module, for generating three-phase six-way complementary PWM waveforms for the circuit structure.

Preferably, the HALL angle mapping module compiles the three HALL signals generated by the HALL module through 3-8 decoder units to generate corresponding register configuration signals for setting phase offsets of the HALL signals, wherein the register configuration signals are processed through AND gates and OR gates to generate the HALL synchronous angle values corresponding to the three HALL signals.

Preferably, the register configuration signals set the phase offsets of the HALL signals through the following process:
the register configuration signals set the phase offsets of the HALL signals corresponding to their respective HALL elements according to the placement of the three HALL elements, and specifically, the register configuration signals include:
register 5 configuration signal, for setting the phase offset of the corresponding HALL signal to 0°;
register 1 configuration signal, for setting the phase offset of the corresponding HALL signal to 60°;
register 3 configuration signal, for setting the phase offset of the corresponding HALL signal to 120°;
register 2 configuration signal, for setting the phase offset of the corresponding HALL signal to 180°;
register 6 configuration signal, for setting the phase offset of the corresponding HALL signal to 240°;
register 4 configuration signal, for setting the phase offset of the corresponding HALL signal to 300°;
wherein by changing the phase offsets of the HALL signals, advanced commutation and lagging commutation are achieved.

Preferably, the HALL angle updating module includes:
a first register, which has a high-level input terminal receiving the HALL synchronous angle values, a clock terminal receiving a clock signal clk, an S input terminal receiving a state update signal HALL_change, and an output terminal outputting a single-phase angle Degree_A generated after processing; and
a first adder, which has a first input terminal receiving the single-phase angle Degree_A for angle addition calculation, a second input terminal receiving a degree incremental signal Degree_inc, and an output terminal outputting an angle variable generated after the addition process to a low-level input terminal of the first register for angle update processing.

Preferably, the three-phase angle generation module includes:
a second register, which has a high-level input terminal receiving a first timing input signal C0 for calculating a sinusoidal signal sin (Degree) at the moment of C0, a clock terminal receiving a system clock signal HCLK, and an output terminal outputting a first synchronous incremental signal Add_1 for calculating a sinusoidal signal sin (Degree +120°) at the moment of Add_1;
a third register, which has a high-level input terminal receiving the first synchronous incremental signal Add_1, a clock terminal receiving the system clock signal HCLK, and an output terminal outputting a second synchronous incremental signal Add_2 for calculating a sinusoidal signal sin (Degree +240°) at the moment of Add_2;
a second adder, which has a first input terminal receiving the sinusoidal signal sin (Degree +120°) at the moment of Add_1 and sinusoidal signal sin (Degree +240°) at the moment of Add_2 after the two are processed by AND gates and an OR gate, a second input terminal receiving the single-phase angle Degree_A, and an output terminal outputting a real-time signal Degree (which is an angle) after addition processing; and
a first subtractor, which has a first input terminal receiving the real-time signal Degree, a second input terminal receiving a degree of 360°, and an output terminal outputting a three-phase degree output sinusoidal signal Sin_degree_pre (which is an angle) generated after the subtraction.

Preferably, the angle conversion module includes:
a first quadrant angle conversion module, for processing a qualified three-phase degree output sinusoidal signal Sin_degree_pre with a first quadrant angle conversion to generate a first quadrant angle signal Degree_1_90, and for processing the first quadrant angle signal Degree_1_90 and the current three-phase degree output sinusoidal signal Sin_ degree_pre with an AND gate and an OR gate to generate a real-time sinusoidal degree signal Sin_degree;
a second quadrant angle conversion module, for processing a qualified three-phase degree output sinusoidal signal Sin_degree_pre with a second quadrant angle conversion to generate a second quadrant angle signal Degree_91_180, and for processing the second quadrant angle signal Degree_91_180 and a degree of (180°-Sin_degree_pre) obtained from angle conversion of the current three-phase degree output sinusoidal signal with an AND gate and an OR gate to generate the real-time sinusoidal degree signal Sin_degree;
a third quadrant angle conversion module, for processing a qualified three-phase degree output sinusoidal signal Sin_degree_pre with a third quadrant angle conversion to generate a third quadrant angle signal Degree_181_270, and for processing the third quadrant angle signal Degree_181 270 and a degree of (Sin degree_pre-180°) obtained from angle conversion of the current three-phase degree output sinusoidal signal with an AND gate and an OR gate to generate the real-time sinusoidal degree signal Sin_degree; and
a fourth quadrant angle conversion module, for processing a qualified three-phase degree output sinusoidal signal Sin_degree_pre with a fourth quadrant angle conversion to generate a fourth quadrant angle signal Degree_271_360, and for processing the fourth quadrant angle signal Degree_271_360 and a degree of (360°-Sin_degree_pre) obtained from angle conversion of the current three-phase degree output sinusoidal signal with an AND gate and an OR gate to generate the real-time sinusoidal degree signal Sin_degree.

Preferably, the PWM generation module includes:
a sinusoidal signal generator, for receiving the real-time sinusoidal signal Sin_degree, which is processed to generate an output sinusoidal signal Sinout;
a second subtractor, which has a first input terminal receiving the output sinusoidal signal Sinout, and a second input terminal receiving a 30° sinusoidal signal, wherein the second subtractor judges the sign of its input signals, and has an output terminal outputting a judgment result signal regarding the sign bit of the input signals;
a first flip-flop module, which has a first input terminal receiving the judgment result signal output by the second subtractor, a clock terminal receiving the first timing input signal C0 and the system clock signal HCLK, and an output terminal connected to an input terminal of a first invertor, wherein an output terminal of the first invertor is connected to a first input terminal of a first AND gate, and a second input terminal of the first AND gate receives an amplitude signal, wherein the on-off status of upper and lower bridges corresponding to the HALL signals is determined according to conduction timing signals;
a second flip-flop module, which has a first input terminal receiving the judgment result signal output by the second subtractor, a clock terminal receiving the first synchronous incremental signal ADD_1 and the system clock signal HCLK, and an output terminal connected to an input terminal of a second invertor, wherein an output terminal of the second invertor is connected to a first input terminal of a second AND gate, and a second input terminal of the second AND gate receives the amplitude signal, wherein the on-off status of upper and lower bridges corresponding to the HALL signals is determined according to conduction timing signals; and
a third flip-flop module, which has a first input terminal receiving the judgment result signal output by the second subtractor, a clock terminal receiving the second synchronous incremental signal ADD_2 and the system clock signal HCLK, and an output terminal connected to an input terminal of a third invertor, wherein an output terminal of the third invertor is connected to a first input terminal of a third AND gate, a second input terminal of the third AND gate receives the amplitude signal, and the on-off status of the upper and lower bridges corresponding to the HALL signal is determined according to conduction timing signals.

Preferably, on-off status of the upper or lower bridge corresponding to the HALL signal varies according to the following rules:
when the conduction timing is in the first quadrant, i.e., the single-phase angle Degree_A and the sinusoidal signal sin (Degree) at the moment of C0 are in the first quadrant (i.e., 0-90 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the second quadrant, i.e., the single-phase angle Degree_A and the sinusoidal signal sin (Degree) at the moment of C0 are in the second quadrant (i.e., 90-180 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the third quadrant, i.e., the single-phase angle Degree_A and the sinusoidal signal sin (Degree) at the moment of C0 are in the third quadrant (i.e., 180-270 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts;
when the conduction timing is in the fourth quadrant, i.e., the single-phase angle Degree_A and the sinusoidal signal sin (Degree) at the moment of C0 are in the fourth quadrant (i.e., 270-360 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts.

The circuit structure for realizing advanced and lagging commutation of motors of the present invention, compared with related art, can more easily achieve advancing and lagging of square wave motors by combining certain hardware structures, which is very intuitive and clear. Logic circuits dedicated to motors are integrated into the circuit structure, and therefore functions like speed acquisition and advanced and lagging commutations can be achieved by assigning values to several registers without multiplication/division and interrupt operations, thereby greatly reducing the software workload. Moreover, advancing and lagging related functions may share the same set of code to reduce program size. For a system that needs to switch between a square wave mode and a sine wave mode, the present disclosure can be applied, to realize direct switching without vibration or transition failure.

### BRIEF DESCRIPTION OF THE DRAWINGS

FIG. 1 is a block diagram of a circuit structure for realizing advanced and lagging commutations of motors of the present disclosure.
FIG. 2 shows waveforms of a PWM generator adopted in a circuit structure for realizing advanced and lagging commutations of motors of the present disclosure.
FIG. 3 shows a working principle of a HALL angle mapping module of the present disclosure.
FIG. 4 shows a working principle of a HALL angle updating module of the present disclosure.
FIG. 5 shows an exemplary generation process of a synchronous incremental signal of a three-phase angle generation module of the present disclosure.
FIG. 6 shows a working principle of a three-phase angle generation module of the present disclosure.
FIG. 7 shows a working principle of an angle conversion module of the present disclosure.
FIG. 8 shows a working principle of a PWM generation module of the present disclosure.

### DETAILED DESCRIPTION

In order to be able to describe the technical content of the present disclosure more clearly, the following is further described in conjunction with specific embodiments.

Before detailing the embodiments of the present disclosure, it should be noted that in the following, the term "includes", "comprises" or any other variant is intended to cover non-exclusive inclusion, such that a process, method, article, or device including a set of elements contains not only those elements, but may also contain other elements that are not explicitly listed or that are inherent to such process, method, article, or device.

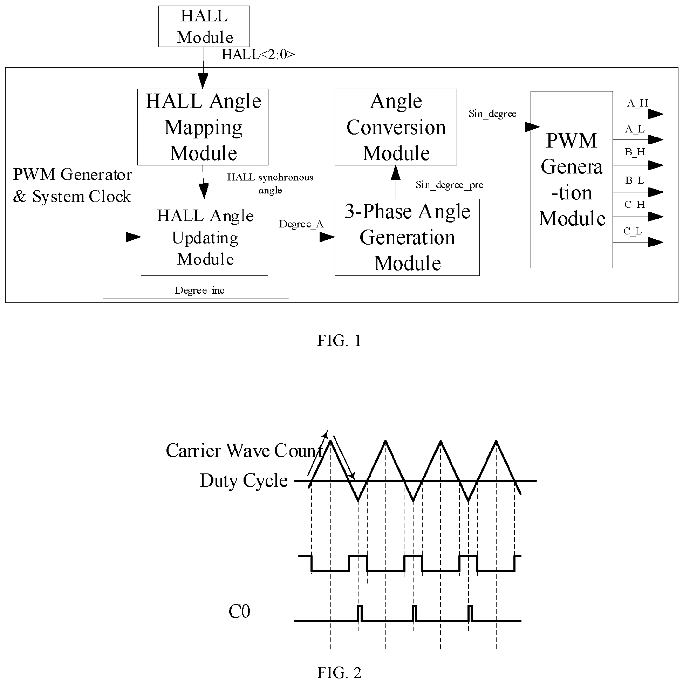

Referring to FIG. 1, the circuit structure for realizing advanced and lagging commutation of motors is shown, which includes:
a HALL angle mapping module, connected to a HALL module of an external motor, for receiving three HALL signals generated by the HALL module and converting the three HALL signals into HALL synchronous angle values, respectively;
a HALL angle updating module, connected to the HALL angle mapping module, for selecting a corresponding angle updating mode according to internal logic of the circuit structure;
a three-phase angle generation module, connected to the HALL angle updating module, for performing a time-sharing calculation of angles generated by the HALL angle updating module to generate a current three-phase angle signal corresponding to the three Hall signals;
an angle conversion module, connected to the three-phase angle generation module, for performing an angle conversion on the three-phase angle signal generated by the three-phase angle generation module; and
a PWM generation module, connected to the angle conversion module, for generating three-phase six-way complementary PWM waveforms for the circuit structure.

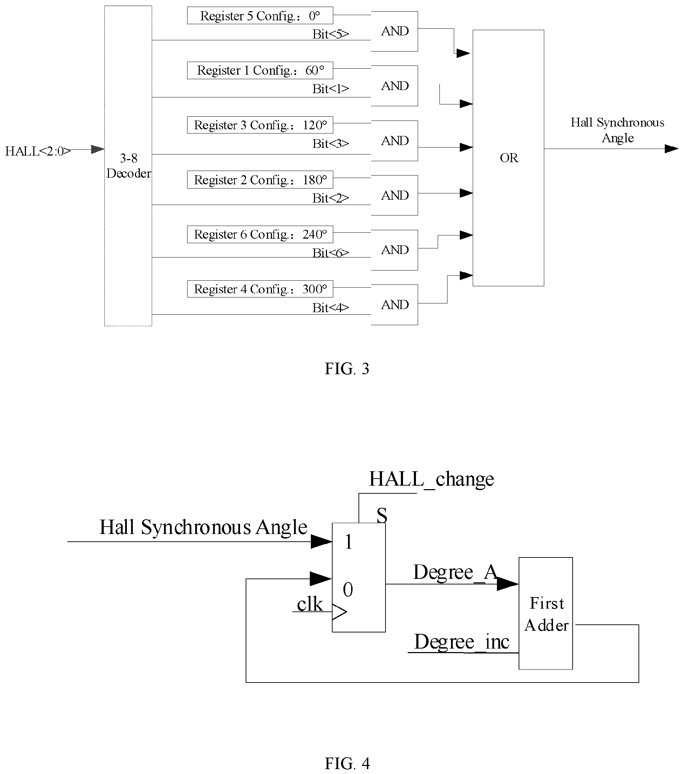

Referring to FIG. 3, as a preferred embodiment of the present disclosure, the HALL angle mapping module compiles the three HALL signals generated by the HALL module of the external motor through 3-8 decoder units and generates corresponding register configuration signals for setting phase offsets of the HALL signals. The register configuration signals are processed through AND gates and an OR gate to generate HALL synchronous angle values corresponding to the three HALL signals.

As a preferred embodiment of the present disclosure, the register configuration signals set the phase offsets of the HALL signals through the following process:
the register configuration signals set the phase offsets of the HALL signals corresponding to their respective HALL elements according to the placement of the three HALL elements. Specifically, the register configuration signals include:
register 5 configuration signals, for setting the phase offset of the corresponding HALL signal to 0°;
register 1 configuration signal, for setting the phase offset of the corresponding HALL signal to 60°;
register 3 configuration signals, for setting the phase offset of the corresponding HALL signal to 120°;
register 2 configuration signals, for setting the phase offset of the corresponding HALL signal to 180°;
register 6 configuration signals, for setting the phase offset of the corresponding HALL signal to 240°; and
register 4 configuration signals, for setting the phase offset of the corresponding HALL signal to 300°.

By changing the phase offsets of the HALL signals, advanced commutation and lagging commutation are achieved.

Referring to FIG. 4, as a preferred embodiment of the present disclosure, the HALL angle updating module includes:
a first register, which has a high-level input terminal receiving the HALL synchronous angle values, a clock terminal receiving a clock signal clk, an S input terminal receiving a state update signal HALL_change, and an output terminal outputting a single-phase angle Degree_A generated after processing; and
a first adder, which has a first input terminal receiving the single-phase angle Degree_A for angle addition calculation, a second input terminal receiving a degree incremental signal Degree_inc, and an output terminal outputting an angle variable generated after the addition process to a low-level input terminal of the first register for angle update processing.

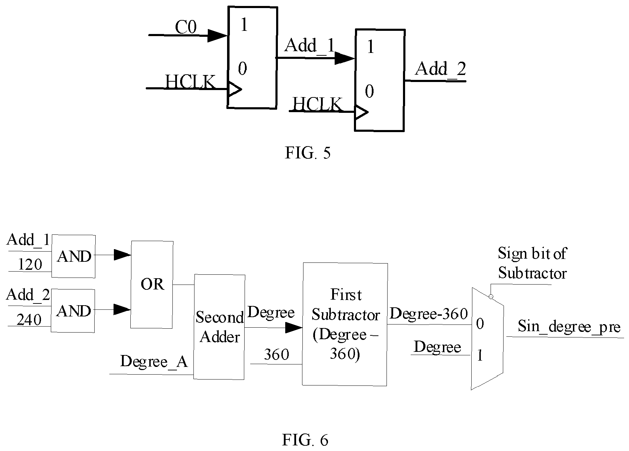

Referring to FIG. 5 and FIG. 6, as a preferred embodiment of the present disclosure, the three-phase angle generation module includes:
a second register, which has a high-level input terminal receiving a first timing input signal C0 for calculating a sinusoidal signal sin (Degree) at the moment of C0, a clock terminal receiving a system clock signal HCLK, and an output terminal outputting a first synchronous incremental signal Add_1 for calculating a sinusoidal signal sin (Degree +120°) at the moment of Add_1;
a third register, which has a high-level input terminal receiving the first synchronous incremental signal Add_1, a clock terminal receiving the system clock signal HCLK, and an output terminal outputting a second synchronous incremental signal Add_2 for calculating a sinusoidal signal sin (Degree +240°) at the moment of Add_2;
a second adder, which has a first input terminal receiving the sinusoidal signal sin (Degree +120°) at the moment of Add_1 and sinusoidal signal sin (Degree +240°) at the moment of Add_2 after the two are processed by AND gates and an OR gate, a second input terminal receiving the single-phase angle Degree_A, and an output terminal outputting a real-time signal Degree (which is an angle) after addition processing; and
a first subtractor, which has a first input terminal receiving the real-time signal Degree, a second input terminal receiving a degree of 360°, and an output terminal outputting a three-phase degree output sinusoidal signal Sin_degree_pre (which is an angle) generated after the subtraction.

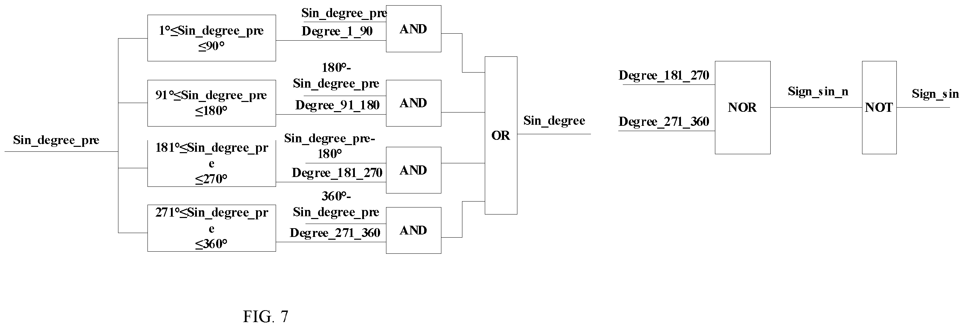

Referring to FIG. 7, as a preferred embodiment of the present disclosure, the angle conversion module includes:
a first quadrant angle conversion module, for processing a qualified three-phase degree output sinusoidal signal Sin_degree_pre with a first quadrant angle conversion to generate a first quadrant angle signal Degree_1_90, and for processing the first quadrant angle signal Degree_1_90 and the current three-phase degree output sinusoidal signal Sin_ degree_pre with an AND gate and an OR gate to generate a real-time sinusoidal degree signal Sin_degree;
a second quadrant angle conversion module, for processing a qualified three-phase degree output sinusoidal signal Sin_degree_pre with a second quadrant angle conversion to generate a second quadrant angle signal Degree_91_180, and for processing the second quadrant angle signal Degree_91_180 and a degree of (180°-Sin_degree_pre) obtained from angle conversion of the current three-phase degree output sinusoidal signal with an AND gate and an OR gate to generate the real-time sinusoidal degree signal Sin_degree;
a third quadrant angle conversion module, for processing a qualified three-phase degree output sinusoidal signal Sin_degree_pre with a third quadrant angle conversion to generate a third quadrant angle signal Degree_181_270, and for processing the third quadrant angle signal Degree_181 270 and a degree of (Sin degree_pre-180°) obtained from angle conversion of the current three-phase degree output sinusoidal signal with an AND gate and an OR gate to generate the real-time sinusoidal degree signal Sin_degree; and
a fourth quadrant angle conversion module, for processing a qualified three-phase degree output sinusoidal signal Sin_degree_pre with a fourth quadrant angle conversion to generate a fourth quadrant angle signal Degree_271_360, and for processing the fourth quadrant angle signal Degree_271_360 and a degree of (360°-Sin_degree_pre) obtained from angle conversion of the current three-phase degree output sinusoidal signal with an AND gate and an OR gate to generate the real-time sinusoidal degree signal Sin_degree.

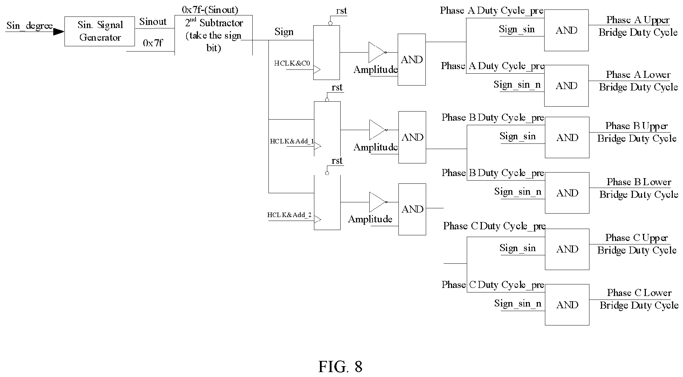

Referring to FIG. 8, as a preferred embodiment of the present disclosure, the PWM generation module includes:
a sinusoidal signal generator, for receiving the real-time sinusoidal signal Sin_degree, which is processed to generate an output sinusoidal signal Sinout;
a second subtractor, which has a first input terminal receiving the output sinusoidal signal Sinout, and a second input terminal receiving a 30° sinusoidal signal, wherein the second subtractor judges the sign of its input signals, and has an output terminal outputting a judgment result signal regarding the sign bit of the input signals;
a first flip-flop module, which has a first input terminal receiving the judgment result signal output by the second subtractor, a clock terminal receiving the first timing input signal C0 and the system clock signal HCLK, and an output terminal connected to an input terminal of a first invertor, wherein an output terminal of the first invertor is connected to a first input terminal of a first AND gate, and a second input terminal of the first AND gate receives an amplitude signal, wherein the on-off status of upper and lower bridges corresponding to the HALL signals is determined according to conduction timing signals;
a second flip-flop module, which has a first input terminal receiving the judgment result signal output by the second subtractor, a clock terminal receiving the first synchronous incremental signal ADD_1 and the system clock signal HCLK, and an output terminal connected to an input terminal of a second invertor, wherein an output terminal of the second invertor is connected to a first input terminal of a second AND gate, and a second input terminal of the second AND gate receives the amplitude signal, wherein the on-off status of upper and lower bridges corresponding to the HALL signals is determined according to conduction timing signals; and
a third flip-flop module, which has a first input terminal receiving the judgment result signal output by the second subtractor, a clock terminal receiving the second synchronous incremental signal ADD_2 and the system clock signal HCLK, and an output terminal connected to an input terminal of a third invertor, wherein an output terminal of the third invertor is connected to a first input terminal of a third AND gate, a second input terminal of the third AND gate receives the amplitude signal, and the on-off status of the upper and lower bridges corresponding to the HALL signal is determined according to conduction timing signals.

As a preferred embodiment of the present disclosure, the on-off status of the upper or lower bridge corresponding to the HALL signal varies according to the following rules:
when the conduction timing is in the first quadrant, i.e., the single-phase angle Degree_A and the sinusoidal signal sin (Degree) at the moment of C0 are in the first quadrant (i.e., 0-90 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the second quadrant, i.e., the single-phase angle Degree_A and the sinusoidal signal sin (Degree) at the moment of C0 are in the second quadrant (i.e., 90-180 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the third quadrant, i.e., the single-phase angle Degree_A and the sinusoidal signal sin (Degree) at the moment of C0 are in the third quadrant (i.e., 180-270 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts;
when the conduction timing is in the fourth quadrant, i.e., the single-phase angle Degree_A and the sinusoidal signal sin (Degree) at the moment of C0 are in the fourth quadrant (i.e., 270-360 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts.

In a specific implementation of the present disclosure, the workflow of the present technical solution is as follows: the three HALL signals generated by the HALL module of the external motor are converted to the HALL synchronous angle values according to the configuration of the HALL angle mapping module, and based on the internal logic of the circuit structure, the HALL angle updating module chooses between adopting a corresponding HALL synchronous angle and performing self-increment according to Degree_inc. Because there is only one sinusoidal signal generator in some embodiments as described above, and the motor to be controlled is a three-phase motor, the three-phase angle generation module is used, and time-sharing calculation is performed on the single-phase angle Degree_A generated by the HALL angle updating module to obtain the three-phase angle and generate the three-phase degree output sinusoidal signal Sin_degree_pre. In addition, because of the various symmetries of sinusoidal functions, only the angles in the first quadrant needs to be calculated. The present disclosure therefore only calculates the phase values for angles from 0° to 90°. So, Sin_degree_pre needs to be converted by the PWM generation module to generate three-phase (labeled as A, B, C, respectively) six-way complementary PWM waveforms. The PWM generator and the system clock are involved in the operation of each of the other modules.

In a specific implementation of the present disclosure, referring to FIG. 2, a PWM generator capable of generating waveforms in FIG. 2 is required for square wave control or sine wave control of the motor of the present disclosure, wherein C0 is the starting point of the PWM signal generated by the PWM generator. The present disclosure achieves the configuration of a three-phase duty cycle by employing only one amplitude register, as well as achieving advanced and/or lagging commutation of the motor.

In a specific implementation of the present disclosure, there may be some differences in the positioning of HALL components among different motors, which may be corrected by modifying the "register x configuration" (x is 1 to 6) in FIG. 3. The control of advanced and/or lagging commutation can be achieved in a similar manner, by biasing the registers as a whole.

### For example:

Ideally, the phase difference between two consecutive signals is 60 degrees, as follows:

| | | | | | |
|---|---|---|---|---|---|
| 5->0° | 4->60° | 6->120° | 2->180° | 3->240° | 1->300° |

However, if the test reveals some lag in phase, it is necessary to add an angle bias of, for example, 20 degrees:

| | | | | | |
|---|---|---|---|---|---|
| 5->20° | 4->80° | 6->140° | 2->200° | 3->260° | 1->320° |

In this way, advanced commutation can be achieved.

Similarly, if the phase is found to be advanced, the base bias needs to be reduced or even a bias in the negative direction is needed, e.g., -10 degrees:

| | | | | | |
|---|---|---|---|---|---|
| 5->350° | 4->50° | 6->110° | 2->170° | 3->230° | 1->290° |

In this way, a lagging commutation is achieved.

Although there are three HALL signals, which theoretically correspond to eight states from 0b000 to 0b111, for three HALL elements placed at angles of 120 degrees apart, their signals only have six combinations. Depending on the direction of rotation, the HALL values are either 5-4-6-2-3-1, or 5-1-3-2-6-4. The present disclosure takes only one of them for example, i.e., the latter, as shown in FIG. 3.

In a specific implementation of the present disclosure, as shown in FIG. 4, a sine wave generator is used to produce a square wave control signal. The calculation of the sine wave requires a higher angular accuracy than the 60° accuracy required for square wave control. Therefore, it is necessary to calculate the motor speed based on a counter value N for every 60°, wherein the corresponding counting clock is the C0 signal (higher accuracy can be set based on actual requirements), and then 60°/N (i.e., degrees per PWM cycle) is a degree increment Degree_inc. At this time, the degree increment Degree_inc is added to a previous single-phase angle Degree_A to obtain a current angle of the HALL signal. The single-phase angle Degree_A is incremented according to the degree increment Degree_inc, and the single-phase angle Degree_A can also be changed with the state change of the HALL signals represented by a signal HALL_change. When HALL_change is updated, rotator position angles represented by the HALL signals will be synchronized to the single-phase angle Degree_A, changing the angle itself. Regarding the "HALL synchronous angle", shown as an input signal in FIG. 4, it can be understood that, for a square wave, the HALL signals indicate a commutation sequence, but for the present disclosure, values of the HALL signals represent synchronous angles, which serve to synchronize angle information when the HALL signals changes, and synchronize the adder's accumulated angle to be the HALL synchronous angle.

In a specific implementation of the present disclosure, there is only one sinusoidal signal generator in the present disclosure, therefore, for a three-phase signal, time-sharing calculation is needed to obtain a three-phase sine wave, wherein C0 is the first timing, the sine calculation used in the present disclosure requires one HCLK clock (system clock), which is then used to obtain an Add_1 signal which corresponds to one HCLK away from C0 (i.e., corresponds to one phase difference) , and an Add_2 signal which corresponds to two HCLK away from C0 (i.e., corresponds to two phase differences), as shown in FIG. 5. When the Add_1 signal is on the rising edge, and when there is an update of HALL information (i.e., HALL_change is 1), the corresponding angle will be updated to Degree_A in the first priority, for example:

| | | | | |
|---|---|---|---|---|
| 5->0° | 4->60°6->120° | 2->180° | 3->240° | 1->300°. |

Then the sine calculation is performed in a time-sharing manner, with sin (Degree) calculated at the moment of C0, sin (Degree +120°) calculated at the moment of Add_1, and sin (Degree + 240°) calculated at the moment of Add_2.

In a specific implementation of the present disclosure, the sine calculation in the present disclosure can only calculate for angles between 0° and 90°, so it may be necessary to convert the angles. As shown in FIG. 7, when the angles are between 0° and 90°, sine calculation is performed directly, when between 90° and 180°, sine calculation is performed using sin (180°-degree), when between 180° and 270°, sine calculation is performed using sin (degree-180°), and when between 270° and 360°, sine calculation is performed using sin (360°-degree). For an angle between 180° and 360°, its corresponding sine value is negative, and the corresponding Sign_sin is 0. When a sine value is positive, the corresponding Sign_sin is 1.

In a specific implementation of the present disclosure, for square wave control, each phase is on for 120 degrees, then suspended for 60 degrees, and then finally the other bridge of the same phase is on; as shown in FIG. 8, the output result of the sinusoidal signal generator ranges from 0 to 1ff, with 0x7f indicating sin 30° and 0x1 ff indicating sin 90°, when the Sin_ degree is in 30°~90°, it means it is the time to conduct, and whether the upper bridge or the lower bridge is conducting depends on the sign bit Sign_sin. For the range of 0°~360°, 30°~150° corresponds to the upper bridge conducting, 210°~330° corresponds to the lower bridge conducting, and the sign bit Sign_sin is 1 within 0°~180° and 0 within 180°~360°, as shown in Table 1.

**Table 1 Angle conversion and upper/lower bridge conduction comparison table**

| Degree_A | Sin_degree (0°~90°) | Sign_sin | Sign_sin_n | Conduction Timing | upper or lower bridge conducts |
|---|---|---|---|---|---|
| 0° ~ 90° | Degree_A | 1 | 0 | 30° ~ 90° | upper bridge conducts |
| 90° ~ 180° | 180-Degree_A | 1 | 0 | 90° ~ 150° | upper bridge conducts |
| 180° ~ 270° | Degree_A-180 | 0 | 1 | 210° ~ 270° | lower bridge conducts |
| 270° ~ 360° | 360-Degree_A | 0 | 1 | 270° ~ 330° | lower bridge conducts |

Meanwhile, the enumeration of each of the above modules in the present disclosure is exemplified with a HALL sensor mode. In fact, the modules can also be applied to back electromotive force (BEMF) in a mode without sensors, and by adjusting configurations of the six registers in the HALL angle mapping module, advanced and lagging commutation can be achieved. Descriptions involving the same or similar parts will not be repeated here.

It should be understood that the various parts of the present disclosure can be implemented in hardware, software, firmware, or a combination thereof. In the above embodiments, a plurality of steps or methods may be implemented with software or firmware stored in memory and executed by a suitable instruction execution device.

One of ordinary skill in the art can understand that implementing all or some of the steps of the method in the above embodiments is accomplished by hardware associated with program instructions, that the program can be stored in a computer readable storage medium, and that, when executed, the program includes one or a combination of the steps of the method embodiment.

In the present disclosure, terms like "an embodiment," "one embodiment," "an example," "specific example", and "some examples" mean that the specific features, structures, materials, or characteristics represented in conjunction with the embodiment or example are included in at least one embodiment or example of the present disclosure. In the present disclosure, when the same expression above is used for several times, it doesn't mean that they refer to the same embodiment or example. Further, the specific features, structures, materials, or characteristics represented in any embodiments or examples may be combined in a suitable manner.

Although embodiments of the present disclosure have been shown and described above, it is understood that the above embodiments are exemplary and shall not be construed as restricting the present disclosure, and that variations, modifications, replacements and variants of the above embodiments may be made by those of ordinary skill in the art within the scope of the present disclosure.

The circuit structure for realizing advanced and lagging commutation of motors of the present disclosure, compared with related art, can more easily achieve advancing and lagging of square wave motors by combining certain hardware structures, which is very intuitive and clear. Logic circuits dedicated to motors are integrated into the circuit structure, and therefore functions like speed acquisition and advanced and lagging commutations can be achieved by assigning values to several registers without multiplication/division and interrupt operations, thereby greatly reducing the software workload. Moreover, advancing and lagging related functions may share the same set of code to reduce program size. For a system that needs to switch between a square wave mode and a sine wave mode, the present disclosure can be applied, to realize direct switching without vibration or transition failure.

In present disclosure, the invention has been described with reference to specific embodiments. However, it is clear that various modifications and transformations can still be made without departing from the spirit and scope of the present disclosure. Therefore, the specification and the accompanying drawings should be considered as illustrative rather than restrictive.

## Claims

1. A circuit structure for realizing advanced and lagging commutation of motors, comprising:
a HALL angle mapping module, connected to a HALL module of an external motor, for receiving three HALL signals generated by the HALL module and converting the three HALL signals into HALL synchronous angle values, respectively;
a HALL angle updating module, connected to the HALL angle mapping module, for selecting a corresponding angle updating mode according to internal logic of the circuit structure;
a three-phase angle generation module, connected to the HALL angle updating module, for performing a time-sharing calculation of angles generated by the HALL angle updating module to generate a three-phase angle signal corresponding to the three HALL signals;
an angle conversion module, connected to the three-phase angle generation module, for performing an angle conversion on the three-phase angle signal generated by the three-phase angle generation module; and
a PWM generation module, connected to the angle conversion module, for generating three-phase six-way complementary PWM waveforms for the circuit structure.

2. The circuit structure for realizing advanced and lagging commutation of motors according to claim 1, wherein the HALL angle mapping module compiles the three HALL signals generated by the HALL module of the external motor through 3-8 decoder units to generate corresponding register configuration signals for setting phase offsets of the HALL signals, wherein the register configuration signals are processed through AND gates and an OR gate to generate the HALL synchronous angle values corresponding to the three HALL signals.

3. The circuit structure for realizing advanced and lagging commutation of motors according to claim 2, wherein the register configuration signals set the phase offsets of the HALL signals through the following process:
the register configuration signals set the phase offsets of the HALL signals corresponding to their respective HALL elements according to the placement of the three HALL elements, and specifically, the register configuration signals include:
register 5 configuration signal, for setting the phase offset of the corresponding HALL signal to 0°;
register 1 configuration signal, for setting the phase offset of the corresponding HALL signal to 60°;
register 3 configuration signal, for setting the phase offset of the corresponding HALL signal to 120°;
register 2 configuration signal, for setting the phase offset of the corresponding HALL signal to 180°;
register 6 configuration signal, for setting the phase offset of the corresponding HALL signal to 240°;
register 4 configuration signal, for setting the phase offset of the corresponding HALL signal to 300°;
wherein by changing the phase offsets of the HALL signals, advanced commutation and lagging commutation are achieved.

4. The circuit structure for realizing advanced and lagging commutation of motors according to claim 3, wherein the register configuration signals compensate for phase lag by increasing an angular bias, and compensate for phase over-advance by decreasing the angular bias or by setting a negative bias.

5. The circuit structure for realizing advanced and lagging commutation of motors according to claim 3, wherein the HALL angle updating module includes:
a first register, which has a high-level input terminal receiving the HALL synchronous angle values, a clock terminal receiving a clock signal clk, an S input terminal receiving a state update signal HALL_change, and an output terminal outputting a single-phase angle Degree_A generated after processing; and
a first adder, which has a first input terminal receiving the single-phase angle Degree_Afor angle addition calculation, a second input terminal receiving a degree incremental signal Degree_inc, and an output terminal outputting an angle variable generated after the addition process to a low-level input terminal of the first register for angle update processing.

6. The circuit structure for realizing advanced and lagging commutation of motors according to claim 5, wherein the three-phase angle generation module includes:
a second register, which has a high-level input terminal receiving a first timing input signal C0 for calculating a sinusoidal signal sin (Degree) at the moment of C0, a clock terminal receiving a system clock signal HCLK, and an output terminal outputting a first synchronous incremental signal Add_1 for calculating a sinusoidal signal sin (Degree +120°) at the moment of Add_1;
a third register, which has a high-level input terminal receiving the first synchronous incremental signal Add_1, a clock terminal receiving the system clock signal HCLK, and an output terminal outputting a second synchronous incremental signal Add_2 for calculating a sinusoidal signal sin (Degree +240°) at the moment of Add_2;
a second adder, which has a first input terminal receiving the sinusoidal signal sin (Degree +120°) at the moment of Add_1 and sinusoidal signal sin (Degree +240°) at the moment of Add_2 after the two are processed by AND gates and an OR gate, a second input terminal receiving the single-phase angle Degree_A, and an output terminal outputting a real-time signal Degree, which is an angle, after addition processing; and
a first subtractor, which has a first input terminal receiving the real-time signal Degree, a second input terminal receiving a degree of 360°, and an output terminal outputting a three-phase degree output sinusoidal signal Sin_degree_pre, which is an angle, generated after the subtraction.

7. The circuit structure for realizing advanced and lagging commutation of motors according to claim 6, wherein the angle conversion module includes:
a first quadrant angle conversion module, for processing a qualified three-phase degree output sinusoidal signal Sin_degree_pre with a first quadrant angle conversion to generate a first quadrant angle signal Degree_1_90, and for processing the first quadrant angle signal Degree_1_90 and the current three-phase degree output sinusoidal signal Sin_ degree_pre with an AND gate and an OR gate to generate a real-time sinusoidal degree signal Sin_degree;
a second quadrant angle conversion module, for processing a qualified three-phase degree output sinusoidal signal Sin_degree_pre with a second quadrant angle conversion to generate a second quadrant angle signal Degree_91_180, and for processing the second quadrant angle signal Degree_91_180 and a degree of (180°-Sin degree_pre) obtained from angle conversion of the current three-phase degree output sinusoidal signal with an AND gate and an OR gate to generate the real-time sinusoidal degree signal Sin_degree;
a third quadrant angle conversion module, for processing a qualified three-phase degree output sinusoidal signal Sin_degree_pre with a third quadrant angle conversion to generate a third quadrant angle signal Degree_181_270, and for processing the third quadrant angle signal Degree_181 270 and a degree of (Sin degree_pre-180°) obtained from angle conversion of the current three-phase degree output sinusoidal signal with an AND gate and an OR gate to generate the real-time sinusoidal degree signal Sin_degree; and
a fourth quadrant angle conversion module, for processing a qualified three-phase degree output sinusoidal signal Sin_degree_pre with a fourth quadrant angle conversion to generate a fourth quadrant angle signal Degree_271_360, and for processing the fourth quadrant angle signal Degree_271_360 and a degree of (360°-Sin_degree_pre) obtained from angle conversion of the current three-phase degree output sinusoidal signal with an AND gate and an OR gate to generate the real-time sinusoidal degree signal Sin_degree.

8. The circuit structure for realizing advanced and lagging commutation of motors according to claim 7, wherein
the first quadrant angle signal Degree_1_90 generated by the first quadrant angle conversion module and the second quadrant angle signal Degree_91_180 generated by the second quadrant angle conversion module correspond to Sign_sin being 1;
the third quadrant angle signal Degree_181_270 generated by the third quadrant angle conversion module and the fourth quadrant angle signal Degree_271_360 generated by the fourth quadrant angle conversion module correspond to Sign_sin being 0.

9. The circuit structure for realizing advanced and lagging commutation of motors according to claim 7, wherein the PWM generation module includes:
a sinusoidal signal generator, for receiving the real-time sinusoidal signal Sin_degree, which is processed to generate an output sinusoidal signal Sinout;
a second subtractor, which has a first input terminal receiving the output sinusoidal signal Sinout, and a second input terminal receiving a 30° sinusoidal signal, wherein the second subtractor judges the sign of its input signals, and has an output terminal outputting a judgment result signal regarding the sign bit of the input signals;
a first flip-flop module, which has a first input terminal receiving the judgment result signal output by the second subtractor, a clock terminal receiving the first timing input signal C0 and the system clock signal HCLK, and an output terminal connected to an input terminal of a first invertor, wherein an output terminal of the first invertor is connected to a first input terminal of a first AND gate, and a second input terminal of the first AND gate receives an amplitude signal, wherein the on-off status of upper and lower bridges corresponding to the HALL signals is determined according to conduction timing signals;
a second flip-flop module, which has a first input terminal receiving the judgment result signal output by the second subtractor, a clock terminal receiving the first synchronous incremental signal ADD_1 and the system clock signal HCLK, and an output terminal connected to an input terminal of a second invertor, wherein an output terminal of the second invertor is connected to a first input terminal of a second AND gate, and a second input terminal of the second AND gate receives the amplitude signal, wherein the on-off status of upper and lower bridges corresponding to the HALL signals is determined according to conduction timing signals; and
a third flip-flop module, which has a first input terminal receiving the judgment result signal output by the second subtractor, a clock terminal receiving the second synchronous incremental signal ADD_2 and the system clock signal HCLK, and an output terminal connected to an input terminal of a third invertor, wherein an output terminal of the third invertor is connected to a first input terminal of a third AND gate, a second input terminal of the third AND gate receives the amplitude signal, and the on-off status of the upper and lower bridges corresponding to the HALL signal is determined according to conduction timing signals.

10. The circuit structure for realizing advanced and lagging commutation of motors according to claim 9, wherein on-off status of the upper or lower bridge corresponding to the HALL signal varies according to the following rules:
when the conduction timing is in the first quadrant, i.e., the single-phase angle Degree_A and the sinusoidal signal sin (Degree) at the moment of C0 are in the first quadrant (i.e., 0-90 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the second quadrant, i.e., the single-phase angle Degree_A and the sinusoidal signal sin (Degree) at the moment of C0 are in the second quadrant (i.e., 90-180 degrees), the sign bit Sign_sin of the upper bridge corresponding to the HALL signal is 1 and the sign bit Sign_sin_n of the lower bridge is 0, which means the upper bridge, not the lower bridge, corresponding to this HALL signal conducts;
when the conduction timing is in the third quadrant, i.e., the single-phase angle Degree_A and the sinusoidal signal sin (Degree) at the moment of C0 are in the third quadrant (i.e., 180-270 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts;
when the conduction timing is in the fourth quadrant, i.e., the single-phase angle Degree_A and the sinusoidal signal sin (Degree) at the moment of C0 are in the fourth quadrant (i.e., 270-360 degrees), the sign bit Sign_sin of the upper bridge corresponding to the HALL signal is 0, and the sign bit Sign_sin_n of the lower bridge is 1, which means the lower bridge, not the upper bridge, corresponding to this HALL signal conducts.

11. The circuit structure for realizing advanced and lagging commutation of motors according to claim 10, wherein an output result of the sinusoidal signal generator ranges from 0 to 1ff, with 0x7f indicating sin 30° and 0x1 ff indicating sin 90°.

12. The circuit structure for realizing advanced and lagging commutation of motors according to claim 11, wherein conduction timing in the first quadrant is 30~90°, conduction timing in the second quadrant is 90~150°, conduction timing in the third quadrant is 210~270°, and conduction timing in the fourth quadrant is 270~330°.

13. The circuit structure for realizing advanced and lagging commutation of motors according to claim 12, wherein conduction timing being within 30°~150° corresponds to an upper bridge conducting, and conduction timing being within 210°~330° corresponds to a lower bridge conducting.
